# EUROPEAN PATENT APPLICATION

(11) **EP 4 614 167 A1**
(43) Date of publication of application: **10.09.2025**
(21) Application number: 23901004.4
(22) Date of filing: 29.11.2023
(51) Int. Cl.: G01R 31/385, G01R 31/392, G01R 19/00, G01R 19/10, G01R 31/367, G01R 31/36

(54) **BATTERY MANAGEMENT DEVICE, AND OPERATION METHOD THEREOF**

(30) Priority: 08.12.2022 KR 20220171007
(71) Applicant: LG Energy Solution, Ltd., Seoul 07335 (KR)
(72) Inventor: KIM, Cheol Taek, Daejeon 34122 (KR); SONG, Yee Gahng, Daejeon 34122 (KR); KIM, Ki Hoon, Daejeon 34122 (KR)
(74) Representative: Plasseraud IP
(86) International application number: PCT/KR2023/019473
(87) International publication number: WO 2024/122985

(57) **Abstract**

A battery management apparatus includes a sensor configured to measure a respective voltage of each of a plurality of battery cells, memory and a controller configured to determine whether a first voltage, which is a difference between an average of voltages of the plurality of battery cells measured at the first time and an average of voltages of the plurality of battery cells measured at the second time, satisfies a first condition, determine whether a second condition is satisfied, based on the first voltage, the respective voltage of each of the plurality of battery cells measured at the first time, and the respective voltage of each of the plurality of battery cells measured at the second time, and for each of the plurality of battery cells, diagnose a respective state of the battery cell , based on a respective deviation of the respective voltage of the battery cell

## Description

### [TECHNICAL FIELD]

### CROSS-REFERENCE TO RELATED APPLICATION

This application claims priority to and the benefit of Korean Patent Application No. 10-2022-0171007 filed in the Korean Intellectual Property Office on December 8, 2022, the entire content of which is incorporated herein by reference.

### TECHNICAL FIELD

Embodiments disclosed herein relate to a battery management apparatus and an operating method thereof.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Battery cells undergo internal deformation and degeneration due to various factors at production and use stages, resulting in physical and chemical characteristics. Due to changes in the physical and chemical characteristics of the battery cells, in a system where two or more battery cells are combined, diagnostic performance of the battery cells may not be obtained for deviations caused by degradation. Accordingly, there is a need for a technique for reducing a misdiagnosis rate while maintaining diagnostic performance of the battery cells by considering a normal level of battery degradation.

### [DISCLOSURE]

### [TECHNICAL PROBLEM]

Embodiments disclosed herein aim to provide a battery management apparatus and an operating method thereof in which it may be determined whether a battery cell may be diagnosed by using group characteristics of a plurality of battery cells.

Embodiments disclosed herein aim to provide a battery management apparatus and an operating method thereof in which a misdiagnosis rate caused by degradation of a plurality of battery cells may be reduced.

Technical problems of the embodiments disclosed herein are not limited to the above-described technical problems, and other unmentioned technical problems would be clearly understood by one of ordinary skill in the art from the following description.

### [TECHNICAL SOLUTION]

A battery management apparatus according to an embodiment disclosed herein includes a sensor configured to measure a respective voltage of each of a plurality of battery cells at each of a first time and a second time, memory and a controller configured to determine whether a first voltage, which is a difference between an average of voltages of the plurality of battery cells measured at the first time and an average of voltages of the plurality of battery cells measured at the second time, satisfies a first condition, determine whether a second condition is satisfied, based on the first voltage, the respective voltage of each of the plurality of battery cells measured at the first time, and the respective voltage of each of the plurality of battery cells measured at the second time, and for each of the plurality of battery cells, diagnose a respective state of the battery cell, based on a respective deviation of the respective voltage of the battery cell, when the first condition or the second condition is satisfied.

In an embodiment, the controller may be further configured to determine that the first condition is satisfied when the first voltage is less than or equal to a first threshold value.

In an embodiment, for each of the plurality of battery cells, the second condition may be related to a difference between the respective voltage of the battery cell measured at the first time and the respective voltage of the battery cell measured at the second time.

In an embodiment, the controller may be further configured to, for each of the plurality of battery cells, calculate a second respective voltage, which is a difference between the respective voltage of the battery cell measured at the first time and the respective voltage of the battery cell measured at the second time and determine whether the second condition is satisfied, based on the first voltage and the second respective voltage of the battery cell.

In an embodiment, the controller may be further configured to, for each of the plurality of battery cells, determine that the second condition is satisfied, when a rate of the battery cell in which a difference between the first voltage and the second respective voltage of the battery cell is less than or equal to a second threshold value is greater than or equal to a third threshold value.

In an embodiment, the controller may be further configured to, for each of the plurality of battery cells, diagnose the state of the battery cell based on the respective deviation of the respective voltage of the battery cell measured at the first time and the respective voltage of the battery cell measured at the second time.

In an embodiment, the respective voltage of the battery cell measured at the first time and the respective voltage of the battery cell measured at the second time may be measured after the battery cell remained idle for a set time.

In an embodiment, for each of the plurality of battery cells, the respective voltage of the battery cell measured at the first time and the respective voltage measured at the second time may be open circuit voltages (OCV).

An operating method of a battery management apparatus according to an embodiment disclosed herein includes obtaining a respective voltage of each of a plurality of battery cells measured at each of a first time and a second time, determining whether a first voltage, which is a difference between an average of voltages of the plurality of battery cells measured at the first time and an average of voltages of the plurality of battery cells measured at the second time, satisfies a first condition, determining whether a second condition is satisfied, based on the first voltage, the respective voltage of each of the plurality of battery cells measured at the first time, and the respective voltage of each of the plurality of battery cells measured at the second time, and diagnosing for each of the plurality of battery cells, a respective state of the battery cell , based on a respective deviation of the respective voltage of the battery cell, when the first condition or the second condition is satisfied.

In an embodiment, the determining of whether the first voltage, which is the difference between the average of voltages of the plurality of battery cells corresponding to the first time and the average of voltages of the plurality of battery cells corresponding to the second time, satisfies the first condition may include determining that the first condition is satisfied when the first voltage is less than or equal to a first threshold value.

In an embodiment, the method further comprises for each of the plurality of battery cells, calculating a second respective voltage, which is a difference between the respective voltage of the battery cell measured at the first time and the respective voltage of the battery cell measured at the second time and determining whether the second condition is satisfied, based on the first voltage and the second voltage of the battery cell.

In an embodiment, the determine of whether the second condition is satisfied, may include for each of the plurality of battery cells, determining that the second condition is satisfied, when a rate of the battery cell in which a difference between the first voltage and the second respective voltage of the battery cell less than or equal to a second threshold value is greater than or equal to a third threshold value.

### [ADVANTAGEOUS EFFECTS]

The battery management apparatus and the operating method thereof according to an embodiment disclosed herein may determine whether a battery cell may be diagnosed by using group characteristics of a plurality of battery cells.

The battery management apparatus and the operating method thereof according to an embodiment disclosed herein may reduce a misdiagnosis rate caused by degradation of a plurality of battery cells.

The battery management apparatus and the operating method thereof according to an embodiment disclosed herein may accurately diagnose a battery cell by pre-checking whether a relative deviation between battery cells is a distribution suitable for abnormality determination.

The battery management apparatus and the operating method thereof according to an embodiment disclosed herein may reduce unnecessary system downtime and response cost by preventing a battery cell in a normal category from being detected in a technique for sorting an abnormality value of a plurality of battery cells, such as internal short-circuit diagnosis, etc.

Moreover, various effects recognized directly or indirectly from the disclosure may be provided.

### [DESCRIPTION OF DRAWINGS]

FIG. 1 is a block diagram showing a configuration of a general battery pack.
FIG. 2 is a block diagram of a battery management apparatus according to an embodiment disclosed herein.
FIGS. 3 and 4 show an example where a battery management apparatus according to an embodiment disclosed herein determines whether voltage deviation diagnosis of a plurality of battery cells is possible.
FIG. 5 is a flowchart of an operating method of a battery management apparatus according to an embodiment disclosed herein.
FIG. 6 is a flowchart showing an operating method of a battery management apparatus, according to an embodiment disclosed herein.
FIG. 7 is a block diagram showing a hardware configuration of a computing system for performing an operating method of a battery management apparatus, according to an embodiment disclosed herein.

### [MODE FOR INVENTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

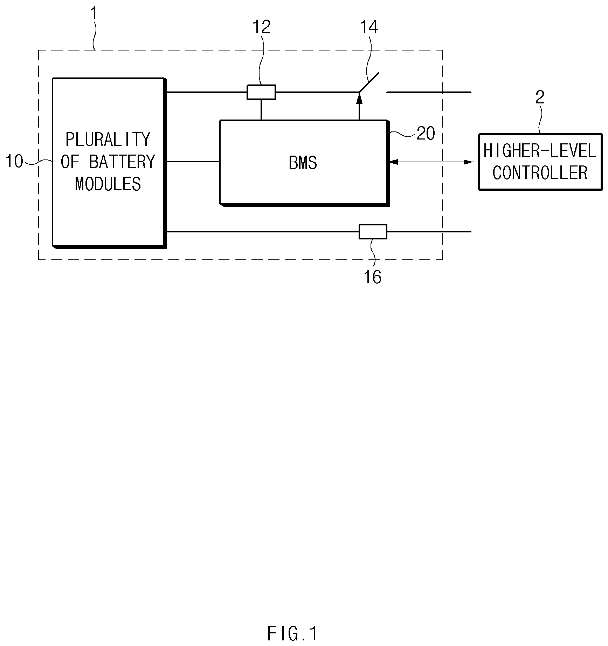

FIG. 1 is a block diagram showing a configuration of a general battery pack.

Referring to FIG. 1, a battery control system including a battery pack 1 and a higher-level controller 2 included in a higher-level system according to an embodiment of the present disclosure is schematically shown.

As shown in FIG. 1, the battery pack 1 may include a battery module 10 that includes one or more battery cells and is chargeable/dischargeable, a switching unit 14 serially connected to a positive (+) terminal side or a negative (-) terminal side of the battery module 10 to control a charging/discharging current flow of the battery module 10, and a battery management system 20 for control and management to prevent overcharging and over-discharging by monitoring voltage, current, temperature, etc., of the battery pack 1. The battery pack 1 may include the battery module 10, the sensor 12, the switching unit 14, and the battery management system 20 provided in plural.

Herein, as the switching unit 14 which is an element for controlling a current flow for charging or discharging of the plurality of battery modules 10, for example, at least one relay, magnetic contactor, etc., may be used according to specifications of the battery pack 1.

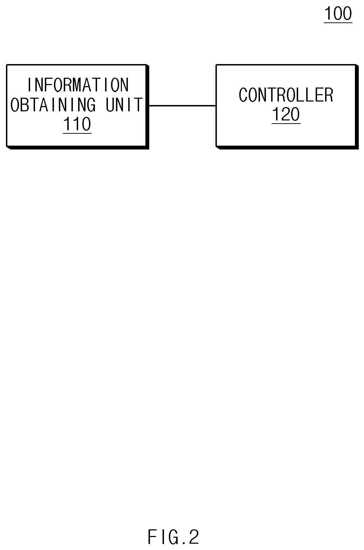

The battery management system 20, which is an interface for receiving measurement values of the above-described various parameter values, may include a plurality of terminals and a circuit, etc., connected thereto to process input values. The battery management system 20 may control on/off of the switching unit 14, e.g., a relay, a contactor, etc., and may be connected to the battery module 10 to monitor the state of each battery module 10. According to an embodiment, the battery management system 20 may include a battery management apparatus 100 of FIG. 2. According to another embodiment, the battery management system 20 may be different from the battery management apparatus 100 of FIG. 2. That is, the battery management apparatus 100 of FIG. 2 may be included in the battery pack 1 and may be configured as another device outside the battery pack 1.

The higher-level controller 2 may transmit a control signal regarding the battery module 10 to the battery management system 20. Thus, the battery management system 20 may also be controlled in terms of an operation thereof based on a signal applied from the higher-level controller 2.

FIG. 2 is a block diagram of a battery management apparatus according to an embodiment disclosed herein.

Referring to FIG. 2, the battery management apparatus 100 according to an embodiment disclosed herein may include an information obtaining unit 110 and a controller 120.

According to an embodiment, the battery management apparatus 100 may be included in the battery management system 20 of FIG. 1. According to another embodiment, the battery management apparatus 100 may be included in the higher-level controller 2 of FIG. 1. According to another embodiment, the battery management apparatus 100 may be included in a separate device not shown in the battery pack 1 of FIG. 1.

The information obtaining unit 110 may obtain a voltage of each of a plurality of battery cells. For example, the information obtaining unit 110 may obtain a voltage of each of the plurality of battery cells in time series. In another example, the information obtaining unit 110 may obtain a voltage of each of the plurality of battery cells corresponding to a first time and a voltage of each of the plurality of battery cells corresponding to a second time. According to an embodiment, the information obtaining unit 110 may obtain the voltage of each of the plurality of battery cells, measured by a voltage sensor.

The controller 120 may determine whether the voltages of the plurality of battery cells satisfy a first condition or a second condition. For example, the controller 120 may diagnose a state of the plurality of battery cells based on a deviation of the voltage of each of the plurality of battery cells, when the voltages of the plurality of battery cells satisfy the first condition or the second condition.

According to an embodiment, the controller 120 may diagnose the state of the plurality of battery cells based on the deviation of the voltage of each of the plurality of battery cells, when at least any one of the first condition or the second condition is satisfied or both the first condition and the second condition are satisfied.

The controller 120 may determine whether a first voltage, which is a difference between an average of voltages of the plurality of battery cells corresponding to the first time and an average of voltages of the plurality of battery cells corresponding to the second time, satisfies the first condition. For example, the controller 120 may determine that the first condition is satisfied when the first voltage is less than or equal to a first threshold value.

According to an embodiment, the first threshold value may be, but not limited to, 20 mV, and may be set differently according to characteristics of a battery cell and a system including the plurality of battery cells.

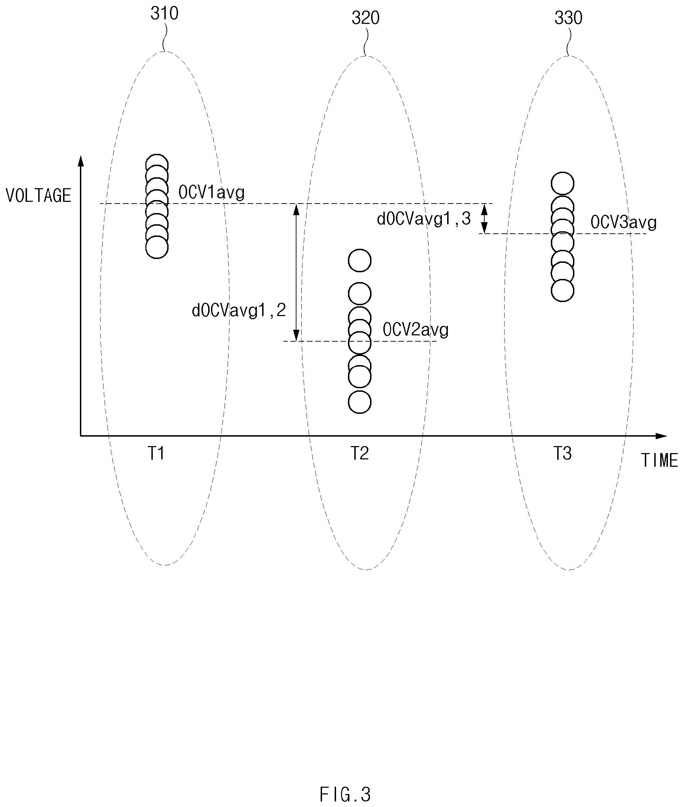

FIG. 3 shows an example where a battery management apparatus according to an embodiment disclosed herein determines whether voltage deviation diagnosis of a plurality of battery cells is possible.

Referring to FIG. 3, the information obtaining unit 110 of the battery management apparatus 100 according to an embodiment disclosed herein may obtain voltages 310, 320, and 330 of the plurality of battery cells corresponding to different times.

The controller 120 may determine whether voltage deviation diagnosis of the plurality of battery cells is possible based on the voltages 310, 320, and 330 of the plurality of battery cells corresponding to the different times. For example, the controller 120 may determine whether voltage deviation diagnosis of the plurality of battery cells is possible based on the voltage 310 of the plurality of battery cells corresponding to a time T1, the voltage 320 of the plurality of battery cells corresponding to a time T2, and the voltage 330 of the plurality of battery cells corresponding to a time T3.

According to an embodiment, the controller 120 may calculate an average of the voltage 310 of the plurality of battery cells corresponding to the time T1, an average of the voltage 320 of the plurality of battery cells corresponding to the time T2, and an average of the voltage 330 of the plurality of battery cells corresponding to the time T3. In this case, the controller 120 may calculate the first voltage, which is a difference between the calculated averages, and determine whether the first voltage satisfies the first condition. For example, the controller 120 may determine whether the difference between the average of the voltage 310 of the plurality of battery cells corresponding to the time T1 and the average of the voltage 320 of the plurality of battery cells corresponding to the time T2 is less than or equal to the threshold value, and determine that the first condition is not satisfied because the difference is not less than or equal to the threshold value. In another example, the controller 120 may determine whether the difference between the average of the voltage 310 of the plurality of battery cells corresponding to the time T1 and the average of the voltage 330 of the plurality of battery cells corresponding to the time T3 is less than or equal to the threshold value, and determine that the first condition is satisfied because the difference is less than or equal to the threshold value.

That is, the battery management apparatus 100 may determine that diagnosis of the state of the plurality of battery cells based on the voltage deviation of the plurality of battery cells is not suitable because an influence of a voltage dispersion of a capacity deviation is great, when the difference between the averages of the voltages of the plurality of battery cells corresponding to different times is greater than the threshold value.

Referring back to FIG. 2, the controller 120 may determine whether the second condition is satisfied, based on the first voltage, the voltage of each of the plurality of battery cells corresponding to the first time, and the voltage of each of the plurality of battery cells corresponding to the second time. For example, the second condition may be related to the difference between the voltage of each of the plurality of battery cells corresponding to the first time and the voltage of each of the plurality of battery cells corresponding to the second time.

According to an embodiment, the controller 120 may calculate a second voltage, which is a difference between the voltage of each of the plurality of battery cells corresponding to the first time and the voltage of each of the plurality of battery cells corresponding to the second time. The controller 120 may also determine whether the second condition is satisfied based on the first voltage (the difference between the average of the voltages of the plurality of battery cells corresponding to the first time and the average of the voltages of the plurality of battery cells corresponding to the second time) and the second voltage of each of the plurality of battery cells. For example, the controller 120 may determine that the second condition is satisfied, when a rate of battery cells in which a difference between the first voltage and the second voltage of each of the plurality of battery cells is less than or equal to a second threshold value is greater than or equal to a third threshold value.

According to an embodiment, the second threshold value may be, but not limited to, 4 mV, and the third threshold value may be, but not limited to, 80 %, and they may be set differently according to characteristics of a battery cell and a system including the plurality of battery cells.

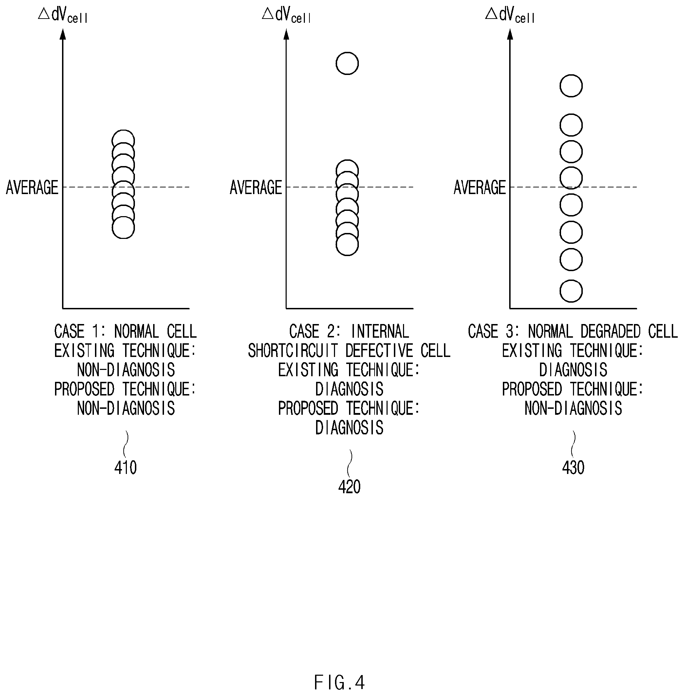

FIG. 4 shows an example where a battery management apparatus according to an embodiment disclosed herein determines whether voltage deviation diagnosis of a plurality of battery cells is possible.

Referring to FIG. 4, the controller 120 of the battery management apparatus 100 according to an embodiment disclosed herein may calculate second voltages 410, 420, and 430 of each of the plurality of battery cells, which are differences between the voltage of each of the plurality of battery cells corresponding to the first time and the voltage of each of the plurality of battery cells corresponding to the second time. The controller 120 may also calculate the first voltage, which is a difference between the voltage of each of the plurality of battery cells corresponding to the first time and the voltage of each of the plurality of battery cells corresponding to the second time.

The controller 120 may compare the first voltage with the second voltage of each of the plurality of battery cells to determine whether the second condition is satisfied.

According to an embodiment, in Case 1, the controller 120 may determine that a rate of battery cells in which a difference between the first voltage and the second voltage of each of the plurality of battery cells is less than or equal to the second threshold value is greater than or equal to the third threshold value, and determine that the second condition is satisfied. In this case, the controller 120 may diagnose a state of the plurality of battery cells based on deviations of the voltages of the plurality of battery cells and determine (non-diagnosis) that the plurality of battery cells are normal.

According to an embodiment, in Case 2, the controller 120 may determine that a rate of battery cells in which a difference between the first voltage and the second voltage of each of the plurality of battery cells is less than or equal to the second threshold value is greater than or equal to the third threshold value, and determine that the second condition is satisfied. In this case, the controller 120 may diagnose a state of the plurality of battery cells based on deviations of the voltages of the plurality of battery cells and diagnose that at least one of the plurality of battery cells is abnormal.

According to an embodiment, in Case 3, the controller 120 may determine that a rate of battery cells in which a difference between the first voltage and the second voltage of each of the plurality of battery cells is less than or equal to the second threshold value is not greater than or equal to the third threshold value, and determine that the second condition is not satisfied. In this case, the controller 120 may not diagnose (non-diagnosis) the state of the plurality of battery cells based on the deviations of the voltages of the plurality of battery cells.

In conclusion, in Case 3, an existing technique may diagnose that the plurality of battery cells are defective while failing to consider the degradation degree of the plurality of battery cells, but the battery management apparatus 100 according to an embodiment disclosed herein may not diagnose the state of the plurality of battery cells based on the voltage deviation of the plurality of battery cells by considering the degradation degree of the plurality of battery cells.

Thus, the battery management apparatus 100 according to an embodiment disclosed herein may prevent misdiagnosis of the state of the plurality of battery cells by pre-checking whether a relative deviation between battery cells is a distribution suitable for abnormality determination.

Referring back to FIG. 2, the controller 120 may diagnose a state of the plurality of battery cells based on a deviation of the voltage of each of the plurality of battery cells, when the first condition or the second condition is satisfied. For example, the controller 120 may diagnose the state of the plurality of battery cells based on deviations of the voltages of the plurality of battery cells corresponding to the first time and the voltages of the plurality of battery cells corresponding to the second time. According to an embodiment, the controller 120 may calculate the amount of change of a difference between voltages of each battery cell corresponding to the first time and the second time, and diagnose micro shortcircuit of the plurality of battery cells based on a trend pattern of the amount of change.

According to an embodiment, the voltages of the plurality of battery cells corresponding to the first time and the voltages of the plurality of battery cells corresponding to the second time may be voltages after the plurality of battery cells are idle for a set time.

According to an embodiment, the voltages of the plurality of battery cells corresponding to the first time and the voltages of the plurality of battery cells corresponding to the second time may be open circuit voltages (OCV).

The battery management apparatus 100 according to an embodiment disclosed herein may solve a problem of misdiagnosis of an existing technique in a process of detecting a difference of voltage behaviors without considering a case where there is a capacity deviation between two or more cell groups due to accumulative use and natural degradation when the existing technique performs micro shortcircuit detection. For example, the battery management apparatus 100 may pre-determine a distribution form of a cell group to block a possibility of even a normal distribution being subject to shortcircuit detection diagnosis, thereby improving accuracy performance of a diagnostic algorithm.

Moreover, the battery management apparatus 100 according to an embodiment disclosed herein may determine whether a battery cell may be diagnosed by using group characteristics of a plurality of battery cells.

The battery management apparatus 100 according to an embodiment disclosed herein may reduce a misdiagnosis rate caused by degradation of a plurality of battery cells.

The battery management apparatus 100 according to an embodiment disclosed herein may accurately diagnose a battery cell by pre-checking whether a relative deviation between battery cells is a distribution suitable for abnormality determination.

The battery management apparatus 100 according to an embodiment disclosed herein may reduce unnecessary system downtime and response cost by preventing a battery cell in a normal category from being detected in a technique for sorting an abnormality value of a plurality of battery cells, such as internal short-circuit diagnosis, etc.

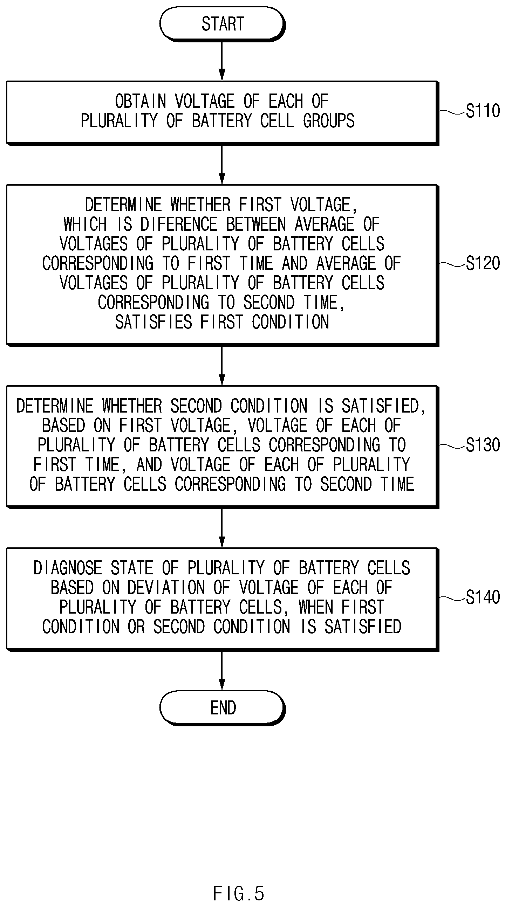

FIG. 5 is a flowchart of an operating method of a battery management apparatus according to an embodiment disclosed herein. According to an embodiment, operations shown in FIG. 5 may be performed by the battery management apparatus 100 of FIG. 2.

Referring to FIG. 5, the operating method of the battery management apparatus 100 according to an embodiment disclosed herein may include operation S110 of obtaining a voltage of each of a plurality of battery cell groups, operation S120 of determining whether a first voltage, which is a difference between an average of voltages of the plurality of battery cells corresponding to a first time and an average of voltages of the plurality of battery cells corresponding to a second time, satisfies a first condition, operation S130 of determining whether a second condition is satisfied, based on the first voltage, a voltage of each of the plurality of battery cells corresponding to a first time, and a voltage of each of the plurality of battery cells corresponding to a second time, and operation S140 of diagnosing a state of the plurality of battery cells based on a deviation of the voltage of each of the plurality of battery cells when the first condition or the second condition is satisfied.

In operation S110, the information obtaining unit 110 may obtain the voltage of each of the plurality of battery cell groups . For example, the information obtaining unit 110 may obtain a voltage of each of the plurality of battery cells in time series.

In operation S120, the controller 120 may determine whether a first voltage, which is a difference between an average of voltages of the plurality of battery cells corresponding to the first time and an average of voltages of the plurality of battery cells corresponding to the second time, satisfies the first condition. For example, the controller 120 may determine that the first condition is satisfied when the first voltage is less than or equal to a first threshold value.

In operation S130, the controller 120 may determine whether the second condition is satisfied, based on the first voltage, the voltage of each of the plurality of battery cells corresponding to the first time, and the voltage of each of the plurality of battery cells corresponding to the second time.

In operation S140, the controller 120 may diagnose a state of the plurality of battery cells based on a deviation of the voltage of each of the plurality of battery cells, when the first condition or the second condition is satisfied.

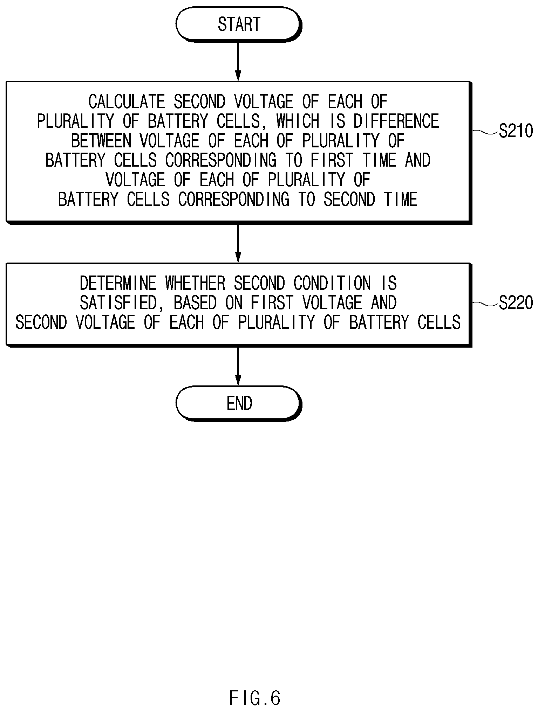

FIG. 6 is a flowchart showing an operating method of a battery management apparatus, according to an embodiment disclosed herein. According to an embodiment, operations shown in FIG. 6 may be performed by the battery management apparatus 100 of FIG. 2.

Referring to FIG. 6, the operating method of the battery management apparatus 100 according to an embodiment disclosed herein may include operation S210 of calculating a second voltage of each of the plurality of battery cells, which is a difference between the voltage of each of the plurality of battery cells corresponding to the first time and the voltage of each of the plurality of battery cells corresponding to the second time, and operation S220 of determining whether a second condition is satisfied, based on the first voltage and the second voltage of each of the plurality of battery cells. According to an embodiment, operations S210 and S220 may be included in operation S130 of FIG. 5.

In operation S210, the controller 120 may calculate a second voltage, which is a difference between the voltage of each of the plurality of battery cells corresponding to the first time and the voltage of each of the plurality of battery cells corresponding to the second time.

In operation S220, the controller 120 may determine whether the second condition is satisfied, based on the first voltage and the second voltage of each of the plurality of battery cells. For example, the controller 120 may determine that the second condition is satisfied, when a rate of battery cells in which a difference between the first voltage and the second voltage of each of the plurality of battery cells is less than or equal to a second threshold value is greater than or equal to a third threshold value.

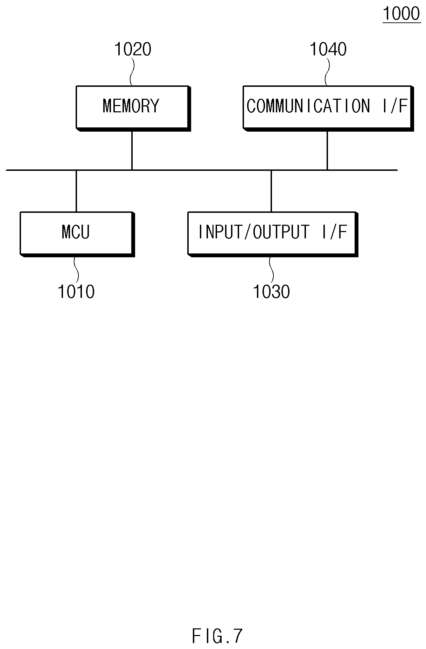

FIG. 7 is a block diagram showing a hardware configuration of a computing system for performing an operating method of a battery management apparatus, according to an embodiment disclosed herein.

Referring to FIG. 7, a computing system 1000 according to an embodiment disclosed herein may include an MCU 1010, a memory 1020, an input/output I/F 1030, and a communication I/F 1040.

The MCU 1010 may be a processor that executes various programs (e.g., a program for collecting voltages of the plurality of battery cells, a program for calculating a voltage difference of the plurality of battery cells, a program for calculating a voltage average of the plurality of battery cells, a program for diagnosing the plurality of battery cells, etc.) stored in the memory 1020, processes various information including the voltages, the voltage difference, and the average of the voltage difference of the plurality of battery cells, etc., through these programs, and executes the above-described functions of the controller included in the battery management apparatus shown in FIG. 2.

The memory 1020 may store various programs such as a program for collecting voltages of the plurality of battery cells, a program for calculating a voltage difference of the plurality of battery cells, a program for calculating the voltage average of the plurality of battery cells, a program for diagnosing the plurality of battery cells, etc. Moreover, the memory 1020 may store various information including the voltages, the voltage difference, and the voltage difference average of the plurality of battery cells, etc.

The memory 1020 may be provided in plural, depending on a need. The memory 1020 may be volatile memory or non-volatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., to the MCU 1010.

The communication I/F 1040, which is a component capable of transmitting and receiving various data to and from a server, may be various devices capable of supporting wired or wireless communication. For example, the battery management apparatus may transmit and receive various information including the voltages, the voltage difference, and the voltage difference average of the plurality of battery cells, etc., from an external server separately provided through the communication I/F 1040.

As such, a computer program according to an embodiment disclosed herein may be recorded in the memory 1020 and processed by the MCU 1010, thus being implemented as a module that performs functions shown in FIG. 2.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present disclosure.

## Claims

1. A battery management apparatus comprising:
a sensor configured to measure a respective voltage of each of a plurality of battery cells at each of a first time and a second time;
memory and
a controller configured to:
determine whether a first voltage, which is a difference between an average of voltages of the plurality of battery cells measured at the first time and an average of voltages of the plurality of battery cells measured at the second time, satisfies a first condition;
determine whether a second condition is satisfied, based on the first voltage, the respective voltage of each of the plurality of battery cells measured at the first time, and the respective voltage of each of the plurality of battery cells measured at the second time; and
for each of the plurality of battery cells, diagnose a respective state of the battery cell based on a respective deviation of the respective voltage of the battery cell, when the first condition or the second condition is satisfied.

2. The battery management apparatus of claim 1, wherein the controller is further configured to determine that the first condition is satisfied when the first voltage is less than or equal to a first threshold value.

3. The battery management apparatus of claim 1, wherein, for each of the plurality of battery cells, the second condition is related to a difference between the respective voltage of the battery cell measured at the first time and the respective voltage of the battery cell measured at the second time.

4. The battery management apparatus of claim 1, wherein the controller is further configured to: for each of the plurality of battery cells,
calculate a second respective voltage, which is a difference between the respective voltage of the battery cell measured at the first time and the respective voltage of the battery cell measured at the second time; and
determine whether the second condition is satisfied, based on the first voltage and the second respective voltage of the battery cell.

5. The battery management apparatus of claim 4, wherein the controller is further configured, for each of the plurality of battery cells, to determine that the second condition is satisfied, when a rate of the battery cell in which a difference between the first voltage and the second respective voltage of the battery cell is less than or equal to a second threshold value is greater than or equal to a third threshold value.

6. The battery management apparatus of claim 1, wherein the controller is further configured, for each of the plurality of battery cells, to determine the state of the battery cell based on the respective deviation of the respective voltage of the battery cell measured at the first time and the respective voltage of the battery cell measured at the second time.

7. The battery management apparatus of claim 1, wherein the respective voltage of the battery cell measured at the first time and the respective voltage of the battery cell measured at the second time are measured after the battery cell remained idle for a set time.

8. The battery management apparatus of claim 1, wherein, for each of the plurality of battery cells, the respective voltage of the battery cell measured at the first time and the respective voltage of the battery cell measured at the second time are open circuit voltages (OCV).

9. An operating method of a battery management apparatus, the operating method comprising:
obtaining a respective voltage of each of a plurality of battery cells measured at each of a first time and a second time;
determining whether a first voltage, which is a difference between an average of voltages of the plurality of battery cells measured at the first time and an average of voltages of the plurality of battery cells measured at the second time, satisfies a first condition;
determining whether a second condition is satisfied, based on the first voltage, the respective voltage of each of the plurality of battery cells measured at the first time, and the respective voltage of each of the plurality of battery cells measured at the second time; and
for each of the plurality of battery cells, diagnosing a respective state of the battery cell, based on a respective deviation of the respective voltage of the battery cell, when the first condition or the second condition is satisfied.

10. The operating method of claim 9, wherein the determining of whether the first voltage, which is the difference between the average of voltages of the plurality of battery cells corresponding to the first time and the average of voltages of the plurality of battery cells corresponding to the second time, satisfies the first condition comprises determining that the first condition is satisfied when the first voltage is less than or equal to a first threshold value.

11. The operating method of claim 9, further comprising: for each of the plurality of battery cells,
calculating a second respective voltage, which is a difference between the respective voltage of the battery cell measured at the first time and the respective voltage of the battery cell measured at the second time; and
determining whether the second condition is satisfied, based on the first voltage and the second respective voltage of the battery cell.

12. The operating method of claim 11, wherein the determining of whether the second condition is satisfied comprises, for each of the plurality of battery cells, determining that the second condition is satisfied, when a rate of the battery cell in which a difference between the first voltage and the second respective voltage of the battery cell is less than or equal to a second threshold value is greater than or equal to a third threshold value.
